# EUROPÄISCHE PATENTSCHRIFT

(11) **EP 2 805 376 B1**
(45) Veröffentlichungstag und Bekanntmachung des Hinweises auf die Patenterteilung: **14.12.2016**
(21) Anmeldenummer: 12714981.3
(22) Anmeldetag: 21.03.2012
(51) Int. Cl.: H01P 7/06, H05H 7/02, H05H 7/18

(54) **RESONATORANORDNUNG UND VERFAHREN ZUM ANREGEN EINES RESONATORS**
RESONATOR ARRANGEMENT AND METHOD FOR EXCITING A RESONATOR
SYSTÈME DE RÉSONATEUR ET PROCÉDÉ D'EXCITATION D'UN RÉSONATEUR

(43) Veröffentlichungstag der Anmeldung: 26.11.2014
(73) Patentinhaber: Siemens Aktiengesellschaft, 80333 München (DE)
(72) Erfinder: HEID, Oliver, 91052 Erlangen (DE); HUGHES, Timothy, 91056 Erlangen (DE); SIRTL, Jennifer, 90763 Fürth (DE)
(86) Internationale Anmeldenummer: PCT/EP2012/054995
(87) Internationale Veröffentlichungsnummer: WO 2013/139389

(56) Entgegenhaltungen:
- US-A- 2 790 905
- US-A- 2 887 580
- US-A1- 2008 068 112
- US-A1- 2010 038 563
- US-A1- 2011 188 638

## Beschreibung

Resonatoranordnung und Verfahren zum Anregen eines Resonators Die vorliegende Erfindung betrifft ein Verfahren zum Anregen eines Resonators gemäß Patentanspruch 1, sowie eine Resonatoranordnung mit einem Resonator und einer Anregevorrichtung gemäß Patentanspruch 7.

Resonatoren, also schwingfähige Systeme, existieren in vielen Varianten. Resonatoren können beispielsweise als RF-Kavitäten ausgebildet sein, in denen sich elektromagnetische Schwingungen anregen lassen. Es ist bekannt, solche RF-Kavitäten in Teilchenbeschleunigern zum Beschleunigen elektrisch geladener Teilchen zu verwenden.

Zum Anregen und Aufrechterhalten einer Resonatorschwingung muss dem Resonator mittels einer Anregevorrichtung von außen Energie zugeführt werden. Bei als RF-Kavitäten ausgebildeten Resonatoren von Teilchenbeschleunigern werden hierzu Hochfrequenzquellen verwendet. Um die Menge der in den Resonator eingespeisten Energie zu regulieren, wird herkömmlicherweise eine Ausgangsamplitude dieser Hochfrequenzquellen reguliert. Insbesondere bei Verwendung von Festkörperschaltern zur Anregung erfordert diese Amplitudenmodulierbarkeit allerdings einen erheblichen Aufwand und reduziert die Effizienz der bekannten Anregevorrichtungen.

Das Dokument US 2 790 905 offenbart ein Verfahren zum Anregen eines Resonators gemäß der Präambel von Anspruch 1.

Die Aufgabe der vorliegenden Erfindung besteht darin, ein verbessertes Verfahren zum Anregen eines Resonators anzugeben. Diese Aufgabe wird durch ein Verfahren mit den Merkmalen des Anspruchs 1 gelöst. Eine weitere Aufgabe der vorliegenden Erfindung besteht darin, eine verbesserte Resonatoranordnung mit einem Resonator und einer Anregevorrichtung bereitzustellen. Diese Aufgabe wird durch eine Resonatoranordnung mit den Merkmalen des Anspruches 7 gelöst. Bevorzugten Weiterbildungen sind in den abhängigen Ansprüchen angegeben.

Bei einem erfindungsgemäßen Verfahren zum Anregen eines Resonators, der eine Resonanzfrequenz aufweist, wird der Resonator während eines ersten Zeitraums mit einer ersten Frequenz angeregt, die sich um eine erste Frequenzdifferenz von der Resonanzfrequenz unterscheidet. Während eines zweiten Zeitraums wird der Resonator mit einer zweiten Frequenz angeregt, die sich um eine zweite Frequenzdifferenz von der Resonanzfrequenz unterscheidet. Dabei weisen die erste Frequenzdifferenz und die zweite Frequenzdifferenz unterschiedliche Vorzeichen auf. Außerdem unterscheiden sich die Beträge der ersten Frequenzdifferenz und der zweiten Frequenzdifferenz um weniger als 10% des größeren Betrags voneinander. Mit anderen Worten liegen die erste Frequenz und die zweite Frequenz also möglichst symmetrisch um die Resonanzfrequenz. Vorteilhafterweise wird dem Resonator durch die Anregung mit den von der Resonanzfrequenz verschiedenen ersten und zweiten Frequenzen weniger Energie zugeführt. Durch die etwa symmetrische Lage der ersten Frequenz und der zweiten Frequenz um die Resonanzfrequenz wird eine durch die Anregung des Resonators mit von der Resonanzfrequenz verschiedenen Frequenzen bewirkte Phasenverschiebung der Resonatorschwingung herausgemittelt. Ausserdem, werden die erste Frequenzdifferenz und die zweite Frequenzdifferenz erhöht, wenn eine Schwingungsamplitude des Resonators reduziert werden soll, und/oder werden die erste Frequenzdifferenz und die zweite Frequendifferenz reduziert, wenn eine Schwingungsamplitude des Resonators erhöht werden soll. Vorteilhafterweise erlaubt es das Verfahren dadurch, die in den Resonator eingespeiste Leistung zu regeln, ohne die Amplitude der Anregung zu variieren. Dadurch ist das Verfahren technisch vorteilhafterweise ohne großen Aufwand umzusetzen.

In einer bevorzugten Ausführungsform des Verfahrens folgen erste Zeiträume und zweite Zeiträume wiederholt aufeinander. Vorteilhafterweise können die ersten Zeiträume und die zweiten Zeiträume dann jeweils sehr kurz bemessen sein, wodurch sich die durch die Anregung des Resonators mit der ersten Frequenz und der zweiten Frequenz bewirkten Phasenverschiebungen der Resonatorschwingung besonders wirksam herausmitteln.

Es ist zweckmäßig, dass der erste Zeitraum und der zweite Zeitraum die gleiche Länge aufweisen. Vorteilhafterweise wird auch hierdurch eine besonders wirksame Herausmittelung von Phasenverschiebungen der Resonatorschwingung unterstützt.

In einer bevorzugten Ausführungsform des Verfahrens wird der Resonator während des ersten Zeitraums und des zweiten Zeitraums mit konstanter Anregungsamplitude angeregt. Vorteilhafterweise kann das Verfahren dann ohne Regulierung der Anregungsamplitude umgesetzt werden.

In einer Weiterbildung des Verfahrens wird der Resonator während eines weiteren Zeitraums mit der Resonanzfrequenz angeregt. Vorteilhafterweise erhöht sich dann die während des weiteren Zeitraums dem Resonator zugeführte Leistung.

Bevorzugt wird der Resonator während des ersten Zeitraums, des zweiten Zeitraums und des weiteren Zeitraums mit konstanter Anregungsamplitude angeregt. Bevorzugt kann zur Anregung des Resonators dann eine Anregevorrichtung verwendet werden, bei der eine Regulierbarkeit der Anregungsamplitude nicht notwendigerweise möglich sein muss.

Eine erfindungsgemäße Resonatoranordnung umfasst einen Resonator und eine Anregevorrichtung zum Anregen einer Schwingung des Resonators. Dabei ist die Anregevorrichtung ausgebildet, ein Verfahren der vorgenannten Art auszuführen. Vorteilhafterweise ist es dann nicht erforderlich, die Anregevorrichtung mit veränderbarer Ausgangsamplitude auszubilden. Dadurch kann die Anregevorrichtung vorteilhafterweise einfach und eine hohe Effizienz aufweisend ausgebildet sein.

In einer Ausführungsform der Resonatoranordnung ist die Schwingung eine elektromagnetische Schwingung. Vorteilhafterweise kann die Resonatoranordnung dann für viele technische Zwecke genutzt werden.

In einer bevorzugten Ausführungsform der Resonatoranordnung ist der Resonator als RF-Kavität ausgebildet. Vorteilhafterweise können RF-Kavitäten für viele technische Zwecke verwendet werden.

In einer besonders bevorzugten Ausführungsform der Resonatoranordnung ist der Resonator ein Resonator eines Teilchenbeschleunigers. Vorteilhafterweise kann der Resonator der Resonatoranordnung dann zur Beschleunigung elektrisch geladener Teilchen verwendet werden. Wegen des enormen Energieverbrauchs von Teilchenbeschleunigern ist eine bei dieser Resonatoranordnung ermöglichte Ausgestaltung der Anregevorrichtung mit hoher Effizienz vorteilhafterweise besonders günstig.

In einer Ausführungsform der Resonatoranordnung weist die Anregevorrichtung einen Festkörperschalter auf. Vorteilhafterweise ermöglicht die Verwendung von Festkörperschaltungen eine kompakte, kostengünstige und energieeffiziente Ausgestaltung der Anregevorrichtung.

Die oben beschriebenen Eigenschaften, Merkmale und Vorteile dieser Erfindung, sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden. Hierbei zeigen:
Figur 1 einen exemplarischen Amplituden-Frequenz-Gang eines Resonators;
Figur 2 ein exemplarisches Diagramm einer Phasenlage zwischen einer Resonatorschwingung und einer externen Anregung;
Figur 3 einen Anregefrequenzverlauf einer Anregung eines Resonators;
Figur 4 einen Amplitudenverlauf einer Resonatorschwingung; und
Figur 5 eine schematische Resonatoranordnung.

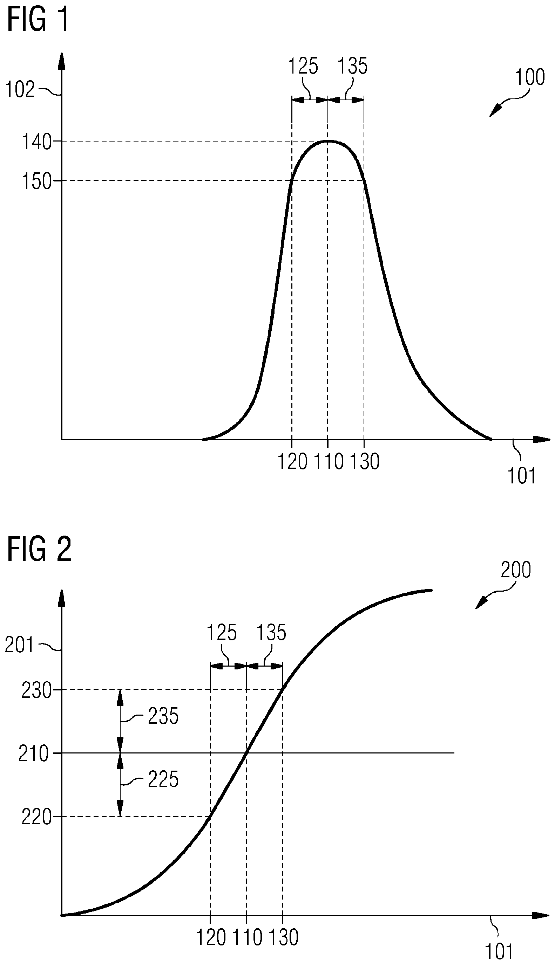

Figur 1 zeigt in schematisierter Darstellung in einem Graphen einen Amplituden-Frequenz-Gang 100 eines Resonators. Grundsätzlich weist jeder Resonator einen vergleichbaren Amplituden-Frequenz-Gang auf. Vorliegend kann der Resonator beispielsweise eine RF-Kavität sein, in der eine elektromagnetische Schwingung angeregt werden kann.

Auf einer horizontalen Achse des Graphen der Figur 1 ist eine Anregungsfrequenz 101 aufgetragen. Die Anregungsfrequenz 101 gibt eine Frequenz an, mit der eine Resonatorschwingung des Resonators von außen angeregt wird. Auf einer vertikalen Achse des Graphen der Figur 1 ist eine Schwingungsamplitude 102 aufgetragen. Die Schwingungsamplitude 102 gibt eine Amplitude der Resonatorschwingung des Resonators an und stellt damit ein Maß für eine in der Resonatorschwingung gespeicherte Energie dar. Der Amplituden-Frequenz-Gang 100 der Figur 1 gibt die Amplitude der Resonatorschwingung an, die sich bei einer Anregung des Resonators mit einer bestimmten Anregungsfrequenz 101 einstellt. Somit gibt der Amplituden-Frequenz-Gang 100 der Figur 1 die abhängig von der Anregungsfrequenz 101 der äußeren Anregung durch die äußere Anregung in den Resonator eingespeiste Energie an.

Der Amplituden-Frequenz-Gang 100 weist bei einer Resonanzfrequenz 110 des Resonators eine maximale Amplitude 140 auf. Bei Anregungsfrequenzen 101, die größer oder kleiner als die Resonanzfrequenz 110 des Resonators sind, fällt die im Resonator angeregte Amplitude ab. So weist die angeregte Resonatorschwingung bei einer reduzierten Frequenz 120, die kleiner als die Resonanzfrequenz 110 ist, nur eine reduzierte Amplitude 150 auf. Bei einer erhöhten Frequenz 130, die größer als die Resonanzfrequenz 110 ist, weist die Resonatorschwingung ebenfalls die reduzierte Amplitude 150 auf. Der Abfall des Amplituden-Frequenz-Gangs 100 außerhalb der Resonanzfrequenz 110 ist umso steiler, je höher die Güte des Resonators ist. Die Amplituden bei der reduzierten Frequenz 120 und bei der erhöhten Frequenz 130 könnten sich auch voneinander unterscheiden.

Die reduzierte Frequenz 120 unterscheidet sich von der Resonanzfrequenz 110 um eine erste Frequenzdifferenz 125. Die erhöhte Frequenz 130 unterscheidet sich von der Resonanzfrequenz 110 um eine zweite Frequenzdifferenz 135. Die erste Frequenzdifferenz 125 und die zweite Frequenzdifferenz 135 weisen unterschiedliche Vorzeichen auf. Bevorzugt weisen die erste Frequenzdifferenz 125 und die zweite Frequenzdifferenz 135 jedoch etwa gleiche Beträge auf. Dann liegt die Resonanzfrequenz 110 mittig zwischen der reduzierten Frequenz 120 und der erhöhten Frequenz 130.

Wird der Resonator mit der Resonanzfrequenz 110 angeregt, so stellt sich eine Resonatorschwingung mit der maximalen Amplitude 140 ein. Die dem Resonator zugeführte Energie ist in diesem Fall maximal. Wird der Resonator mit der reduzierten Frequenz 120 oder mit der erhöhten Frequenz 130 angeregt, so stellt sich eine Resonatorschwingung mit der reduzierten Amplitude 150 ein. In diesem Fall wird durch die äußere Anregung also weniger Energie in den Resonator eingespeist. Somit kann durch eine Variation der Anregungsfrequenz 101, mit der der Resonator angeregt wird, die in den Resonator eingespeiste Energie variiert werden.

Figur 2 zeigt in schematisierter Darstellung einen Graphen einer Phasenlage 200 zwischen der äußeren Anregung des Resonators und der sich im Resonator einstellenden Resonatorschwingung. Auf einer horizontalen Achse ist wiederum die Anregungsfrequenz 101 der äußeren Anregung aufgetragen. Auf einer vertikalen Achse ist eine Phasenverschiebung 201 zwischen der äußeren Anregung und der Resonatorschwingung aufgetragen.

Bei einer Anregung des Resonators mit der Resonanzfrequenz 110 stellt sich eine resonante Phasenlage 210 zwischen der äußeren Anregung und der Resonatorschwingung ein. Die resonante Phasenlage 210 kann beispielsweise eine Phasenverschiebung von 90° zwischen der Anregung und der Resonatorschwingung sein. Außerhalb der Resonanzfrequenz 110 ändert sich die Phasenverschiebung 201 zwischen Anregung und Resonatorschwingung. So stellt sich bei einer Anregung des Resonators mit der reduzierten Frequenz 120 eine erste Phasenlage 220 und bei einer Anregung des Resonators mit der erhöhten Frequenz 130 eine zweite Phasenlage 230 ein. Dies ist in der Regel unerwünscht. Gewünscht ist, dass die Phasenverschiebung 201 zwischen der äußeren Anregung und der Resonatorschwingung bei der resonanten Phasenlage 210 verbleibt.

Im in Figuren 1 und 2 dargestellten Beispiel sind die reduzierte Frequenz 120 und die erhöhte Frequenz 130 allerdings so gewählt, dass sich die erste Phasenlage 220 von der resonanten Phasenlage 210 um eine erste Phasenlage-Änderung 225 unterscheidet, und sich die zweite Phasenlage 230 von der resonanten Phasenlage 210 um eine zweite Phasenlage-Änderung 235 unterscheidet. Dabei weisen die erste Phasenlage-Änderung 225 und die zweite Phasenlage-Änderung 235 unterschiedliche Vorzeichen, jedoch etwa gleiche Beträge auf.

Die reduzierte Frequenz 120 und die erhöhte Frequenz 130 sind also so gewählt, dass die sich bei Anregung mit der reduzierten Frequenz 120 einstellende erste Phasenlage 220 und die sich bei Anregung mit der erhöhten Frequenz 130 einstellende Phasenlage 230 möglichst symmetrisch um die resonante Phasenlage 210 angeordnet sind, die erste Phasenlage-Änderung 225 und die zweite Phasenlage-Änderung 235 also möglichst identische Beträge aufweisen. Weniger wichtig ist, ob sich bei Anregung mit der reduzierten Frequenz 120 und bei Anregung mit der erhöhten Frequenz 130 die gleiche reduzierte Amplitude 150 einstellt. Es ist unkritisch, wenn sich bei der reduzierten Frequenz 120 eine andere Schwingungsamplitude 102 einstellt, als bei der erhöhten Frequenz 130.

Bei Verwendung eines Resonators mit hoher Güte ist die genannte Forderung erfüllt, wenn die reduzierte Frequenz 120 und die erhöhte Frequenz 130 etwa symmetrisch um die Resonanzfrequenz 110 angeordnet sind, die erste Frequenzdifferenz 125 und die zweite Frequenzdifferenz 135 also etwa gleiche Beträge aufweisen. Bevorzugt unterscheiden sich die Beträge der ersten Frequenzdifferenz 125 und der zweiten Frequenzdifferenz 135 um weniger als 10% des größeren Betrags. Besonders bevorzugt unterschieden sich die Beträge der ersten Frequenzdifferenz 125 und der zweiten Frequenzdifferenz 135 um einen noch wesentlich geringeren Bruchteil, beispielsweise um lediglich 5% oder 1% des größeren Betrags.

Wird der Resonator abwechselnd mit der reduzierten Frequenz 120 und der erhöhten Frequenz 130 angeregt, so kompensieren sich die sich ergebenden Phasenlage-Änderungen 225, 235 gegenseitig. Diese Kompensation funktioniert umso besser, je schneller die Intervalle der Anregung mit der reduzierten Frequenz 120 und mit der erhöhten Frequenz 130 aufeinander folgen. Dies kann beispielsweise erreicht werden, indem die Anregungsfrequenz kontrolliert mit einem Jitter beaufschlagt wird.

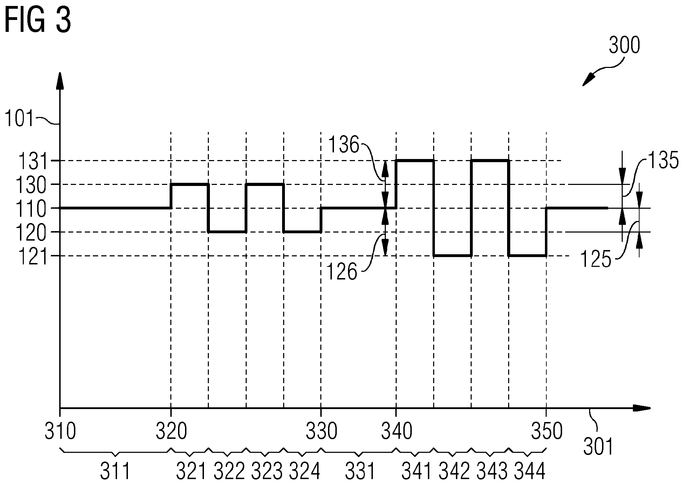

Figur 3 zeigt einen schematischen Anregefrequenzverlauf 300, durch den eine Leistungssteuerung eines Resonators erfolgt, ohne dabei eine Amplitude der Anregung des Resonators zu verändern. Auf einer horizontalen Achse des Graphen der Figur 3 ist eine Zeit 301 aufgetragen. Auf einer vertikalen Achse des Graphen ist die Anregungsfrequenz 101 aufgetragen, mit der der Resonator angeregt wird.

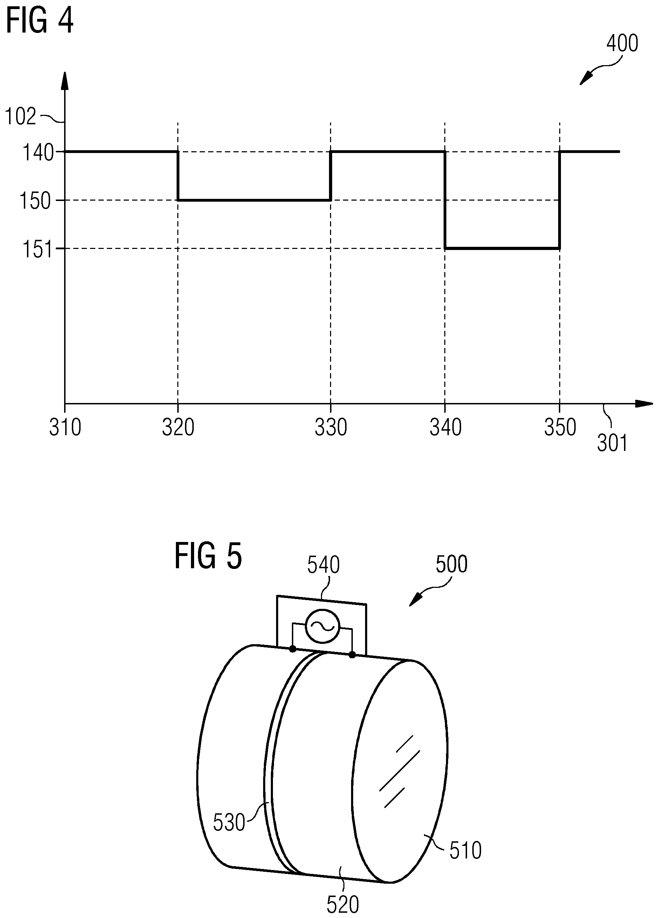

Figur 4 zeigt in einem schematisierten Graphen einen Amplitudenverlauf 400 der Schwingungsamplitude der Resonatorschwingung, die sich während der Anregung des Resonators gemäß des Anregungsfrequenzverlaufs 300 der Figur 3 einstellt. Auf der horizontalen Achse des Graphen der Figur 4 ist somit ebenfalls die Zeit 301 aufgetragen. Auf der vertikalen Achse des Graphen ist die Schwingungsamplitude 102 der Resonatorschwingung dargestellt.

Während eines ersten Zeitraums 311 zwischen einem ersten Zeitpunkt 310 und einem dem ersten Zeitpunkt 310 zeitlich nachfolgenden zweiten Zeitpunkt 320 wird der Resonator mit der Resonatorfrequenz 110 angeregt. Somit stellt sich zwischen dem ersten Zeitpunkt 310 und dem zweiten Zeitpunkt 320 im Resonator die maximale Amplitude 140 der Resonatorschwingung ein.

Zwischen dem zweiten Zeitpunkt 320 und einem dritten Zeitpunkt 330 soll die in den Resonator eingespeiste Energie reduziert werden. Hierzu ist die Zeit zwischen dem zweiten Zeitpunkt 320 und dem dritten Zeitpunkt 330 in einen zweiten Zeitraum 321, einen dritten Zeitraum 322, einen vierten Zeitraum 323 und einen fünften Zeitraum 324 unterteilt. Die Zeiträume 321, 322, 323, 324 dauern bevorzugt jeweils etwa gleich lang. Während des zweiten Zeitraums 321 und des vierten Zeitraums 323 wird der Resonator mit der erhöhten Frequenz 130 angeregt. Während des dritten Zeitraums 322 und des fünften Zeitraums 324 wird der Resonator mit der reduzierten Frequenz 120 angeregt. Folglich stellt sich zwischen dem zweiten Zeitpunkt 320 und dem dritten Zeitpunkt 330 im Resonator eine Resonatorschwingung mit der reduzierten Amplitude 150 ein. Zwischen dem zweiten Zeitpunkt 320 und dem dritten Zeitpunkt 330 ist die in den Resonator eingespeiste Leistung also geringer als zwischen dem ersten Zeitpunkt 310 und dem zweiten Zeitpunkt 320. Da der Resonator zwischen dem zweiten Zeitpunkt 320 und dem dritten Zeitpunkt 330 immer abwechselnd mit der erhöhten Frequenz 130 und der reduzierten Frequenz 120 angeregt wird, mitteln sich die sich dabei ergebenden Phasenlage-Änderungen 225, 235 zwischen der Anregung und der Resonatorschwingung heraus. Somit verbleibt die Phasenverschiebung 201 zwischen der Anregung und der Resonatorschwingung im zeitlichen Mittel bei der resonanten Phasenlage 210.

In den schematischen Darstellungen der Figuren 3 und 4 wird der Resonator zwischen dem zweiten Zeitpunkt 320 und dem dritten Zeitpunkt 330 lediglich während zweier Zeiträume 321, 323 mit der erhöhten Frequenz 130 und während zweier Zeiträume 322, 324 mit der reduzierten Frequenz 120 angeregt. Bevorzugt wird das zeitliche Intervall zwischen dem zweiten Zeitpunkt 320 und dem dritten Zeitpunkt 330 jedoch in wesentlich mehr einzelne Zeiträume mit unterschiedlicher Anregungsfrequenz 101 unterteilt. Die reduzierte Frequenz 120 und die erhöhte Frequenz 130 wechseln sich also wesentlich häufiger ab.

Während eines sechsten Zeitraums 331 zwischen dem dritten Zeitpunkt 330 und einem vierten Zeitpunkt 340 wird der Resonator wieder mit der Resonanzfrequenz 110 angeregt. Dadurch nimmt die Resonatorschwingung zwischen dem dritten Zeitpunkt 330 und dem vierten Zeitpunkt 340 wieder die maximale Amplitude 140 an. Zwischen dem dritten Zeitpunkt 330 und dem vierten Zeitpunkt 340 ist die in dem Resonator eingespeiste Leistung somit wieder maximal.

Zwischen dem vierten Zeitpunkt 340 und einem fünften Zeitpunkt 350 soll die in den Resonator eingespeiste Leistung noch weiter reduziert werden als zwischen dem zweiten Zeitpunkt 320 und dem dritten Zeitpunkt 330. Dies wird erreicht, indem der Resonator zwischen dem vierten Zeitpunkt 340 und dem fünften Zeitpunkt 350 wechselweise mit einer zweiten reduzierten Frequenz 121 und einer zweiten erhöhten Frequenz 131 angeregt wird. Die zweite reduzierte Frequenz 121 unterscheidet sich dabei von der Resonanzfrequenz 110 um eine dritte Frequenzdifferenz 126. Die zweite erhöhte Frequenz 131 unterscheidet sich von der Resonanzfrequenz 110 des Resonators um eine vierte Frequenzdifferenz 136.

Die dritte Frequenzdifferenz 126 und die vierte Frequenzdifferenz 136 weisen unterschiedliche Vorzeichen und etwa übereinstimmende Beträge auf. Der Betrag der dritten Frequenzdifferenz 126 ist jedoch größer als der Betrag der ersten Frequenzdifferenz 125. Der Betrag der vierten Frequenzdifferenz 136 ist größer als der Betrag der zweiten Frequenzdifferenz 135. Aus Figur 1 ist ersichtlich, dass durch die gegenüber den Frequenzdifferenzen 125, 135 erhöhten Frequenzdifferenzen 126, 136 die bei Anregung mit der zweiten erhöhten Frequenz 131 und der zweiten reduzierten Frequenz 121 in den Resonator eingespeiste Leistung gegenüber einer Anregung des Resonators mit der reduzierten Frequenz 120 und der erhöhten Frequenz 130 zusätzlich reduziert ist.

In der schematischen Darstellung der Figuren 3 und 4 ist das zeitliche Intervall zwischen dem vierten Zeitpunkt 340 und dem fünften Zeitpunkt 350 in einen siebten Zeitraum 341, einen achten Zeitraum 342, einen neunten Zeitraum 343 und einen zehnten Zeitraum 344 unterteilt. Das zeitliche Intervall zwischen dem vierten Zeitpunkt 340 und dem fünften Zeitpunkt 350 könnte jedoch auch in eine wesentlich größere Anzahl einzelner Zeiträume unterteilt sein. Während des siebten Zeitraums 341 und des neunten Zeitraums 343 wird der Resonator mit der zweiten erhöhten Frequenz 131 angeregt. Während des achten Zeitraums 342 und des zehnten Zeitraums 344 wird der Resonator mit der zweiten reduzierten Frequenz 121 angeregt. In der Folge stellt sich zwischen dem vierten Zeitpunkt 340 und dem fünften Zeitpunkt 350 im Resonator eine Schwingung mit einer zweiten reduzierten Amplitude 151 ein. Die zweite reduzierte Amplitude 151 ist niedriger als die maximale Amplitude 140 und auch niedriger als die reduzierte Amplitude 150. Somit ist die zwischen dem vierten Zeitpunkt 340 und dem fünften Zeitpunkt 350 in den Resonator eingespeiste Leistung niedriger als während jeder anderen Zeit zwischen dem ersten Zeitpunkt 310 und dem vierten Zeitpunkt 340.

Dadurch, dass die dritte Frequenzdifferenz 126 und die vierte Frequenzdifferenz 136 etwa gleiche Beträge aufweisen, die zweite reduzierte Frequenz 121 und die zweite erhöhte Frequenz 131 also etwa symmetrisch um die Resonanzfrequenz 110 angeordnet sind, kompensieren sich die durch die Anregung des Resonators mit der zweiten reduzierten Frequenz 121 und der zweiten erhöhten Frequenz 131 einstellenden Phasenlage-Änderungen zwischen der Anregung und der Resonatorschwingung im zeitlichen Mittel zwischen dem vierten Zeitpunkt 340 und dem fünften Zeitpunkt 350.

Das anhand der Figuren 1 bis 4 erläuterte Verfahren erlaubt somit eine Leistungssteuerung eines Resonators. Dabei muss die Anregungsamplitude, mit der der Resonator angeregt wird, bei diesem Verfahren nicht variiert werden. Stattdessen wird die Frequenz variiert, mit der der Resonator angeregt wird. Wird der Resonator mit seiner Resonanzfrequenz angeregt, so ist die in den Resonator eingespeiste Leistung maximal. Wird der Resonator mit einer von der Resonanzfrequenz verschiedenen Frequenz angeregt, so reduziert sich die in den Resonator eingespeiste Leistung, wobei sich allerdings auch eine Phasenverschiebung zwischen der Anregung und der Resonatorschwingung verändert. Wird der Resonator jedoch schnell abwechselnd mit zwei unterschiedlichen Frequenzen angeregt, die etwa symmetrisch um die Resonanzfrequenz liegen, so mitteln sich die sich ergebenden Phasenverschiebungen heraus. Je weiter die beiden Anregungsfrequenz von der Resonanzfrequenz des Resonators entfernt liegen, desto stärker reduziert sich die in den Resonator eingespeiste Leistung. Das Verfahren funktioniert umso besser, je höher die Güte des Resonators ist. Die Variation der Anregungsfrequenz kann durch Beaufschlagung der Anregungsfrequenz mit Jitter erfolgen.

Figur 5 zeigt in schematisierter Darstellung eine beispielhafte Resonatoranordnung 500, die zur Durchführung des beschriebenen Verfahrens geeignet ist. Die Resonatoranordnung 500 kann beispielsweise eine Resonatoranordnung in einem Teilchenbeschleuniger zur Beschleunigung elektrisch geladener Teilchen sein.

Die Resonatoranordnung 500 umfasst einen Resonator 510. Der Resonator 510 ist im dargestellten Beispiel als RF-Kavität ausgebildet. Der Resonator 510 ist im dargestellten Beispiel ein sogenannter Pillbox-Resonator mit einer zylindrischen Form. Eine Mantelfläche des zylindrischen Resonators 510 wird durch eine metallische Resonatorwandung 520 gebildet.

Im Resonator 510 kann eine elektromagnetische Schwingung angeregt werden. Hierzu weist die Resonatorwandung 520 einen umlaufenden Schlitz 530 auf, in dem ein elektrisch isolierendes Material angeordnet ist. Über den Schlitz 530 ist eine Anregevorrichtung 540 angeordnet, die bevorzugt einen Festkörperschalter aufweist. Mittels der Anregevorrichtung 540 kann zwischen den beiden durch den Schlitz 530 voneinander abgegrenzten Abschnitten der Resonatorwandung 520 ein hochfrequenter elektrischer Stromfluss induziert werden, wodurch eine Resonatorschwingung im Resonator 510 angeregt wird.

Die Anregevorrichtung 540 ist ausgebildet, den Resonator 510 gemäß des vorab beschriebenen Verfahrens anzuregen. Die Anregevorrichtung 540 variiert zur Steuerung der in den Resonator 510 eingespeisten Leistung also die Frequenz der über den Schlitz 530 der Resonatorwandung 520 angelegten Spannung. Die Ausgangsamplitude der Anregevorrichtung 540 bleibt dabei konstant. Dies hat den Vorteil, dass die Anregevorrichtung 540 mit einer festen Verstärkerkette ausgebildet sein kann, die nicht veränderlich sein muss. Hierdurch ergibt sich vorteilhafterweise ein einfacher Aufbau der Anregevorrichtung 540. Außerdem ermöglicht dies, die Anregevorrichtung 540 vorteilhafterweise mit hohem Wirkungsgrad auszubilden.

Obwohl die Erfindung im Detail durch das bevorzugte Ausführungsbeispiel näher illustriert und beschrieben wurde, ist die Erfindung nicht durch die offenbarten Beispiele eingeschränkt. Andere Variationen können vom Fachmann hieraus abgeleitet werden, ohne den Schutzumfang der Erfindung zu verlassen.

## Patentansprüche

1. Verfahren zum Anregen eines Resonators (510),
wobei der Resonator (510) eine Resonanzfrequenz (110) aufweist,
wobei der Resonator (510) während eines ersten Zeitraums (321, 323, 341, 343) mit einer ersten Frequenz (130, 131) angeregt wird, die sich um eine erste Frequenzdifferenz (135, 136) von der Resonanzfrequenz (110) unterscheidet,
wobei der Resonator (510) während eines zweiten Zeitraums (322, 324, 342, 344) mit einer zweiten Frequenz (120, 121) angeregt wird, die sich um eine zweite Frequenzdifferenz (125, 126) von der Resonanzfrequenz (110) unterscheidet,
wobei die erste Frequenzdifferenz (135, 136) und die zweite Frequenzdifferenz (125, 126) unterschiedliche Vorzeichen aufweisen,
wobei sich die Beträge der ersten Frequenzdifferenz (135, 136) und der zweiten Frequenzdifferenz (125, 126) um weniger als 10% des größeren Betrags unterscheiden, **dadurch gekennzeichnet, dass**
die erste Frequenzdifferenz (135, 136) und die zweite Frequenzdifferenz (125, 126) erhöht werden, wenn eine Schwingungsamplitude (102) des Resonators (510) reduziert
werden soll, und/oder
die erste Frequenzdifferenz (135, 136) und die zweite Frequenzdifferenz (125, 126) reduziert werden, wenn eine Schwingungsamplitude (102) des Resonators (510) erhöht
werden soll.

2. Verfahren gemäß Anspruch 1,
wobei erste Zeiträume (321, 323, 341, 343) und zweite Zeiträume (322, 324, 342, 344) wiederholt aufeinander folgen.

3. Verfahren gemäß einem der vorhergehenden Ansprüche, wobei der erste Zeitraum (321, 323, 341, 343) und der zweite Zeitraum (322, 324, 342, 344) die gleiche Länge aufweisen.

4. Verfahren gemäß einem der vorhergehenden Ansprüche,
wobei der Resonator (510) während des ersten Zeitraums (321, 323, 341, 343) und des zweiten Zeitraums (322, 324, 342, 344) mit konstanter Anregungsamplitude angeregt wird.

5. Verfahren gemäß einem der vorhergehenden Ansprüche, wobei der Resonator (510) während eines weiteren Zeitraums (311, 331) mit der Resonanzfrequenz (110) angeregt wird.

6. Verfahren gemäß Anspruch 5,
wobei der Resonator (510) während des ersten Zeitraums (321, 323, 341, 343), des zweiten Zeitraums (322, 324, 342, 344) und des weiteren Zeitraums (311, 331) mit konstanter Anregungsamplitude angeregt wird.

7. Resonatoranordnung (500)
mit einem Resonator (510) und einer Anregevorrichtung (540) zum Anregen einer Schwingung des Resonators (510), wobei die Anregevorrichtung (540) ausgebildet ist, ein Verfahren nach einem der vorhergehenden Ansprüche auszuführen.

8. Resonatoranordnung (500) gemäß Anspruch 7,
wobei die Schwingung eine elektromagnetische Schwingung ist.

9. Resonatoranordnung (500) gemäß Anspruch 8,
wobei der Resonator (510) als RF-Kavität ausgebildet ist.

10. Resonatoranordnung (500) gemäß einem der Ansprüche 7 bis 9,
wobei der Resonator (510) ein Resonator eines Teilchenbeschleunigers ist.

11. Resonatoranordnung (500) gemäß einem der Ansprüche 7 bis 10,
wobei die Anregevorrichtung (540) einen Festkörperschalter aufweist.

## Claims

1. Method for exciting a resonator (510),
wherein the resonator (510) has a resonant frequency (110),
wherein the resonator (510) is excited during a first time period (321, 323, 341, 343) with a first frequency (130, 131) which differs from the resonant frequency (110) by a first frequency difference (135, 136),
wherein the resonator (510) is excited during a second time period (322, 324, 342, 344) with a second frequency (120, 121) which differs from the resonant frequency (110) by a second frequency difference (125, 126), wherein the first frequency difference (135, 136) and the second frequency difference (125, 126) have different signs,
wherein the magnitudes of the first frequency difference (135, 136) and of the second frequency difference (125, 126) differ by less than 10% of the larger magnitude, **characterized in that**
the first frequency difference (135, 136) and the second frequency difference (125, 126) are increased if an oscillation amplitude (102) of the resonator (510) is to be reduced, and/or
the first frequency difference (135, 136) and the second frequency difference (125, 126) are reduced if an oscillation amplitude (102) of the resonator (510) is to be increased.

2. Method according to Claim 1,
wherein first time periods (321, 323, 341, 343) and second time periods (322, 324, 342, 344) repeatedly follow one another.

3. Method according to one of the preceding claims,
wherein the first time period (321, 323, 341, 343) and the second time period (322, 324, 342, 344) have the same length.

4. Method according to one of the preceding claims,
wherein the resonator (510) is excited with a constant excitation amplitude during the first time period (321, 323, 341, 343) and the second time period (322, 324, 342, 344).

5. Method according to one of the preceding claims,
wherein the resonator (510) is excited with the resonant frequency (110) during a further time period (311, 331).

6. Method according to Claim 5,
wherein the resonator (510) is excited with a constant excitation amplitude during the first time period (321, 323, 341, 343), the second time period (322, 324, 342, 344) and the further time period (311, 331).

7. Resonator arrangement (500)
comprising a resonator (510) and an excitation device (540) for exciting an oscillation of the resonator (510), wherein the excitation device (540) is embodied to carry out a method according to one of the preceding claims.

8. Resonator arrangement (500) according to Claim 7,
wherein the oscillation is an electromagnetic oscillation.

9. Resonator arrangement (500) according to Claim 8,
wherein the resonator (510) is embodied as an RF cavity.

10. Resonator arrangement (500) according to one of Claims 7 to 9,
wherein the resonator (510) is a resonator of a particle accelerator.

11. Resonator arrangement (500) according to one of Claims 7 to 10,
wherein the excitation device (540) comprises a solid-state switch.

## Revendications

1. Procédé d'excitation d'un résonateur (510),
dans lequel le résonateur (510) présente une fréquence de résonance (110),
dans lequel on excite le résonateur (510) pendant un premier intervalle de temps (321, 323, 341, 343) avec une première fréquence (130, 131), qui diffère de la fréquence de résonance (110) d'une première différence de fréquence (135, 136),
dans lequel on excite le résonateur (510) pendant un deuxième intervalle de temps (322, 324, 342, 344) avec une deuxième fréquence (120, 121), qui diffère de la fréquence de résonance (110) d'une deuxième différence de fréquence (125, 126),
dans lequel la première différence de fréquence (135, 136) et la deuxième différence de fréquence (125, 126) présentent des signes différents,
dans lequel les valeurs de la première différence de fréquence (135, 136) et de la deuxième différence de fréquence (125, 126) diffèrent de moins de 10 % de la valeur la plus élevée, **caractérisé en ce que**
on augmente la première différence de fréquence (135, 136) et la deuxième différence de fréquence (125, 126), lorsqu'une amplitude d'oscillation (102) du résonateur (510) doit être réduite, et/ou
on réduit la première différence de fréquence (135, 136) et la deuxième différence de fréquence (125, 126), lorsqu'une amplitude d'oscillation (102) du résonateur (510) doit être accrue.

2. Procédé selon la revendication 1, dans lequel des premiers intervalles de temps (321, 323, 341, 343) et des deuxièmes intervalles de temps (322, 324, 342, 344) se succèdent de façon répétée.

3. Procédé selon l'une quelconque des revendications précédentes, dans lequel le premier intervalle de temps (321, 323, 341, 343) et le deuxième intervalle de temps (322, 324, 342, 344) présentent la même longueur.

4. Procédé selon l'une quelconque des revendications précédentes, dans lequel on excite le résonateur (510) pendant le premier intervalle de temps (321, 323, 341, 343) et pendant le deuxième intervalle de temps (322, 324, 342, 344) avec une amplitude d'excitation constante.

5. Procédé selon l'une quelconque des revendications précédentes, dans lequel on excite le résonateur (510) pendant un autre intervalle de temps (311, 331) avec la fréquence de résonance (110).

6. Procédé selon la revendication 5, dans lequel on excite le résonateur (510) pendant le premier intervalle de temps (321, 323, 341, 343), le deuxième intervalle de temps (322, 324, 342, 344) et l'autre intervalle de temps (311, 331) avec une amplitude d'excitation constante.

7. Système de résonateur (500) avec un résonateur (510) et un dispositif d'excitation (540) destiné à exciter une oscillation du résonateur (510), dans lequel le dispositif d'excitation (540) est conçu pour exécuter un procédé selon l'une quelconque des revendications précédentes.

8. Système de résonateur (500) selon la revendication 7, dans lequel l'oscillation est une oscillation électromagnétique.

9. Système de résonateur (500) selon la revendication 8, dans lequel le résonateur (510) est réalisé sous la forme d'une cavité RF.

10. Système de résonateur (500) selon l'une quelconque des revendications 7 à 9, dans lequel le résonateur (510) est un résonateur d'un accélérateur de particules.

11. Système de résonateur (500) selon l'une quelconque des revendications 7 à 10, dans lequel le dispositif d'excitation (540) présente un interrupteur monolithique.
